# EUROPEAN PATENT APPLICATION

(11) **EP 1 632 466 A1**
(43) Date of publication of application: **08.03.2006**
(21) Application number: 04745353.5
(22) Date of filing: 20.05.2004
(51) Int. Cl.: C04B 41/91, H01L 41/22, H03H 3/02

(54) **PIEZOELECTRIC MATERIAL WORKING METHOD**

(30) Priority: 21.05.2003 JP 2003142894
(71) Applicant: Japan Science and Technology Corporation, Kawaguchi-shi, Saitama 332-0012 (JP)
(72) Inventor: ABE, Takashi, Sendai-shi, Miyagi 980-0855 (JP); LI, Li, Sendai-shi, Miyagi 981-0935 (JP); ESASHI, Masayoshi, Sendai-shi, Miyagi 982-0807 (JP)
(74) Representative: Müller-Boré & Partner Patentanwälte
(86) International application number: PCT/JP2004/007220
(87) International publication number: WO 2004/103932

(57) **Abstract**

After a resist mask 14 with a predetermined thickness profile is overlaid on a piezoelectric substrate 11, the substrate 11 is shaped to an objective three-dimensional configuration by dry etching process using an etching gas with a differential etching rate between the piezoelectric substrate 11 and the mask 14. The thickness profile may be given to the mask 14 by reflow of masking material or by compression with a precision stamp. The substrate 11 can be shaped to a three-dimensional configuration corresponding to an amplified thickness profile of the mask 14 by compositional control of a reactive gas during dry etching. Since the piezoelectric material is accurately shaped to an objective form without defects, high-quality elements and devices are provided.

## Description

### BACKGROUND OF THE INVENTION

### Field of the Invention

The present invention relates to a method of shaping piezoelectric material such as quartz, PZT (lead zirconate titanate) or LiNbO₃ to a predetermined configuration suitable for control of ultrasonic oscillation as well as improvement of oscillation characteristic.

### Description of Related Art

Piezoelectric material is used in various fields, e.g. oscillation sources of reference frequency or clocks for electric or electronic devices. Recently, researches and developments have been focused on how to make it thinner for high performance of information processing and transmission and how to shape it to a predetermined dome for achievement of high quality.

As for a large-scale oscillator of several millimeters or more in diameter, piezoelectric material is trimmed by wet etching and then shaped to a curved surface configuration by grinding its convex edges. As for a small-size oscillator of 1 mm or less in diameter, the piezoeletric material is shaped to a concave configuration for improvement of performance with less support loss. For instance, JP 2002-368572A proposes a concaving method, whereby piezoelectric material is formed to an intermediate configuration near a final form and then dry etched to the final form.

In a mechanical grinding process, piezoelectric material surface is ground with abrasive cloth attached to a level block, but crystallinity of the piezoelectric material is often damaged. It is also impossible to finish all of small-size oscillators, which are located on a grinding table, to objective configurations with a high degree of dimensional freedom. A concaving process aims at a decrease in thickness for improvement of high-frequency characteristics or at reduction of support loss for an increase of Q-value, but has the disadvantage that localization of big mass at a center of an oscillator is hardly realized due to difficulty in shaping to a three-dimensional configuration. Consequently, the oscillator sometimes vibrates irregularly with irrelevance to magnitude of loading mass.

### SUMMARY OF THE INVENTION

The present invention aims at provision of piezoelectric material, which is precisely shaped to a three-dimensional configuration by a new process suitable for production of oscillators with large surface areas, micro-miniaturization, dense integration and an increase of designing freedom.

The new process is characterized by overlaying a mask, which has a thickness profile corresponding to an objective configuration, on piezoelectric material as a workpiece in prior to dry etching. Namely, a mask, which is made of material different in etching rate from piezoelectric material, is deposited on a surface of the piezoelectric material and patterned to a certain shape. Thereafter, a predetermined thickness profile is imparted to the mask by melting the mask with a heat or pressing a precision stamp onto the mask. A thin film, which amplifies a differential etching rate, may be interposed between the piezoelectric material and the mask.

When the piezoelectric material covered with the mask is dry etched, the piezoelectric material is shaped to a configuration corresponding to the thickness profile of the mask. Transcript of the thickness profile of the mask to the piezoelectric material is controlled by changing an etching atmosphere during dry etching. For instance, the mask and a surface layer of the piezoelectric material are both etched in a gas composition with less reactivity at an initial stage of dry etching, and then the etching atmosphere is changed to a gas composition, which preferentially reacts to the piezoelectric material.

### BRIEF DESCRIPTION OF THE DRAWING

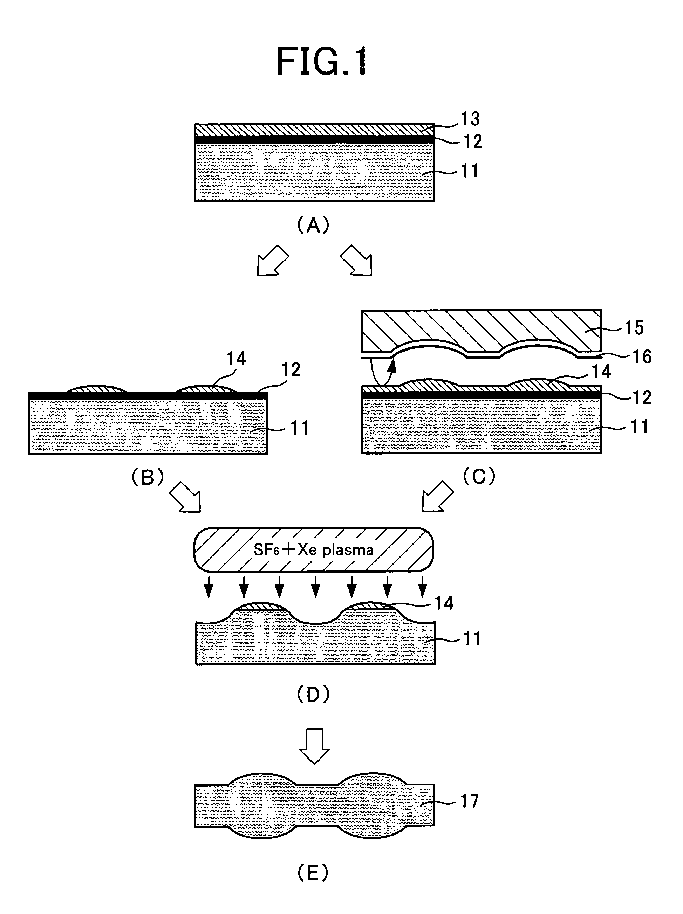

**Fig. 1** is a flow chart for explanation of shaping piezoelectric material to a three-dimensional configuration.

### PREFERRED EMBODIMENT OF THE INVENTION

According to the present invention, piezoelectric material is shaped to a three-dimensional configuration corresponding to a thickness profile of a mask by dry etching. Transcript of the thickness profile from the mask to the piezoelectric material is amplified by proper selection of masking material in relation with the piezoelectric material so as to control a difference in etching rate between the mask and the piezoelectric material, or by changing an etching atmosphere from a gas composition with less reactivity to a gas composition, which preferentially reacts to the piezoelectric material. Piezoelectric material, even which has a large surface area, can be shaped to a complex configuration with ease. Due to dry etching, the piezoelectric material is shaped to high-quality piezoelectric elements, which has intra-plane mass distribution controlled in response to demand characteristics with less introduction of distortion or less inclusion of foreign matters, which leads to crystal defects.

Impartment of proper intra-plane mass distribution to a piezoelectric element, which has oscillation characteristic dependent on mass, is necessary for efficient transformation of an electric energy to a mechanical oscillation energy. In this consequence, a shaping process for three-dimensional control of mass distribution is important to provide oscillators, which well meets such demands as measurement of adsorbates under a big load or transmission of oscillation outside.

A mechanical or laser shaping process has the advantage that a workpiece can be shaped with a high degree of freedom, but piezoelectric material is generally brittle and often changes its crystalline structure due to affection of a work heat. Therefore, a proper process shall be employed for production of high-quality oscillators, instead of the mechanical or laser shaping process. In this sense, dry etching is a process suitable for precisely shaping piezoelectric material to a three-dimensional configuration without damages of a crystalline structure, since mechanical or thermal stress is not introduced to the piezoelectric material during dry etching. The dry etching process is also suitable for production of miniaturized elements or mass-production of large number of elements.

The other features of the invention will become apparent from the following explanation for shaping a convex quartz resonator microbalance.

At first, a workpiece 11 (a piezoelectric substrate) is coated with a mask 13. A film 12 for amplification of a differential etching rate may be optionally interposed between the piezoelectric substrate 11 and the mask 13, in order to properly control a differential etching rate. The amplifying film 12 is prepared from inorganic metal or ceramics, which has an etching rate different from the piezoelectric substrate 11,

A photo-resist is applied to the piezoelectric substrate 11, and then exposed to a light source under the condition that a photo-resist film is irradiated with a smaller quantity of light at its periphery than at its center. The exposed photo-resist film is then developed to a mask 14, which has the thickness profile that the mask 14 is thick at a center but gradually becomes thinner toward a periphery An etching rate of the photo-resist mask 14 is generally higher than that of the piezoelectric substrate 11, so that a undulation of a convex-concave pattern, which is imparted to a surface of the piezoelectric substrate 11 by dry etching under normal conditions, is reduced in comparison with the thickness profile of the mask 14.

In order to impart three-dimensional configurations with more height difference to the piezoelectric material, another mask 14 with a smaller etching rate is overlaid on a piezoelectric substrate 11 by reflow of a low-melting inorganic metal or ceramic such as tin, low-melting glass or frit, as shown in Fig. 1B. The mask 14 may be overlaid on the amplifying film 12.

A mask 13 is also reformed to a mask 14 with a controlled thickness profile by pressing a precision stamp 15, which is fixed to a separate base, onto the mask 13, as shown in Fig. 1C. In this case, a parting sheet is preferably attached to a functional surface of the precision stamp 15 facing to the mask 13, in order to facilitate detachment of the precision stamp 15 from the reformed mask 14.

Either by reflow or by pressing with the precision stamp 15, the mask 13 is reformed to the mask 14 having the thickness profile that the mask 14 is thick at a center but gradually becomes thinner toward a periphery.

When the piezoelectric substrate 11 is dry etched after deposition of the mask 14 with the controlled thickness profile, its surface is shaped to a configuration corresponding to the thickness profile, as shown in Fig. 1D. Finally, a piezoelectric element 17 with an objective form is produced.

A convex-concave configuration, which is imparted to the piezoelectric substrate 11, is also controlled by a differential etching rate between the piezoelectric substrate 11 and the mask 14. For instance, the differential etching rate is properly controlled by a ratio of a selectively reactive gas to a unselectively reactive gas, both of which are commonly used in a dry etching process. The selectively reactive gas is perfluorocarbon, SF₆, chlorine or iodine, as a source for supplying radicals or the like to selectively shape or etch the piezoelectric substrate 11. The unselectively reactive gas is Ar, Kr or Xe, which physically etches the piezoelectric substrate 11 without selectivity. The differential etching rate is also controlled by an input power for plasma generation.

For instance, a gas composition, which contains a large volume of an unselectively reactive gas, is replaced by a gas composition, which contains a large volume of a selectively reactive gas, during dry etching a reformed photo-resist mask 14. In a first step of dry etching with the unselectively reactive gas-enriched composition, a thickness profile of the mask 14 is transcribed to a surface of the piezoelectric substrate 11. In a latter step of dry etching with the selectively reactive gas-enriched composition, the piezoelectric substrate 11 is preferentially etched. Consequently, the thickness profile of the mask 14 is amplified, and the piezoelectric substrate 11 is shaped to a three-dimensional configuration corresponding to the amplified thickness profile.

The invention will be more clearly understood from the following examples referring to the drawing.

### Example 1

PZT was provided as a piezoelectric substrate 11. A positive resist was applied to the piezoelectric substrate 11 by a spin coating method to deposit a photo-resist film 13 of 7 µm in thickness. The photo-resist film 13 was exposed using a grating mask and reformed to a mask 14 having a controlled thickness profile. The reformed mask 14 had a cross section with a periodically serrated pattern.

Thereafter, the thickness profile of the mask 14 was transcribed to a surface of the piezoelectric substrate 11 by reactive dry etching. When the dry etching was performed with SF₆ as an etching gas in a decompressed atmosphere of 10 Pa or lower, PZT was etched at an etching rate of 0.1-0.2 µm/minute, and a differential etching rate of the photo-resist mask 14 to PZT was about 0.2. As a result, a periodic pattern of 1 µm or so in intervals was imparted to PZT.

A piezoelectric element was produced by patterning electrodes on the etched PZT. When the piezoelectric element, which supported a minute object thereon, was charged with a voltage, the minute object shifted along a predetermined direction.

### Example 2

Quartz was provided as a piezoelectric substrate 11. A positive resist was applied to the piezoelectric substrate 11 by a spin coating method to deposit a photo-resist film 13 of 4 µm in thickness. The photo-resist film 13 was patterned and then heat-treated. During the heat-treatment, a heating temperature was gradually raised so as to reflow the photo-resist to a dome. As a result, the photo-resist film 13 was reformed to a mask 14 having a controlled thickness profile.

Thereafter, a thickness profile of the mask 14 was transcribed to the substrate 11, by a reactive dry etching process using an etching gas of SF₆ mixed with Xe in a decompressed atmosphere of 10 Pa or lower. An etching ratio of the photoresist to the quartz was about 0.3, and the quartz was etched at a rate of 0.4-0.6 µm/minute. As a result, the quartz was reformed to a three-dimensional configuration corresponding to the thickness profile of the mask 14.

A piezoelectric device, prepared by etching a quartz substrate together with a mask 14 having a convex configuration of 1-2 µm in height, had excellent oscillation characteristics and Q value two times higher than that of an un-etched device. Spurious oscillation was also decreased by nearly one digit.

### Example 3

A positive photoresist was applied to quartz as a piezoelectric substrate 11 by spinning process, so as to deposit a resist film of 4 µm in thickness on the substrate 11. The resist film was patterned. Thereafter, the resist film was subjected to heat treatment, wherein the resist film was reformed to a dome due to reflow of resist material by gradual temperature rising. As a result, the resist film was shaped to a mask 14 having a controlled thickness profile.

Thereafter, the thickness profile of the mask 14 was transcribed to the substrate 11, by dry etching the substrate 11 and the mask 14 with a reactive gas in a decompressed atmosphere of 10 Pa or less. Gaseous mixture of SF₆ and Xe was used as the reactive gas. At the beginning of etching, dry etching was continued 3 minutes with a reactive gas having a compositional ratio of SF₆ : Xe controlled to 9 : 1, so that a slope of 1 µm in height was formed at a boundary between a convex of the mask 14 and the substrate 11. Thereafter, the compositional ratio was changed to 1 : 1 in a few seconds by a flow controller. In response to change of the compositional change, an etching ratio and a quartz-etching rate were remarkably changed from 0.2 to 0.4 and from 0.4 µm/minute to 0.2 µm/minute, respectively. Due to the decrease in the etching ratio and the etching rate, the boundary between the mask 14 and the substrate 11 was reformed to a slope with gradual inclination.

The piezoelectric element, prepared in this way, was used as a device well resistant to dulling of resonance frequency due to the curved profile allotted to the center.

### INDUSTRIAL APPLICABILITY

According to the invention as mentioned the above, a piezoelectric substrate 11 is dry etched together with a mask 14 having a controlled thickness profile, so that the substrate 11 can be shaped to an objective three-dimensional configuration with higher accuracy than a conventional wet etching-mechanical polishing process. The new process also has the advantage that the substrate can be easily shaped to a profile having a large mass at its center. Piezoelectric elements, produced from piezoelectric substrates processed in this way, are useful over broad technical and industrial fields, e.g. as molecular-recognizing sensors for detecting a small amount of biochemical or chemical substance, due to excellent stability of oscillation property in correspondence with mass loading.

## Claims

1. A method of shaping a piezoelectric material, comprising the steps of:
depositing a resist mask directly to or through a film for amplification of an etching ratio to a surface of a piezoelectric material;
reforming the resist mask to a predetermined thickness profile; and
dry etching the piezoelectric material together with the resist mask,
wherein the piezoelectric material and the resist mask are etched at an etching rate different from each other, thereby the surface of the piezoelectric material being shaped to a three-dimensional configuration corresponding to the thickness profile of the resist mask.

2. The method defined in Claim 1, wherein the thickness profile is given to the resist mask by patterning and melting a masking material applied to the surface of the piezoelectric material.

3. The method defined in Claim 1, wherein the thickness profile is given to the resist mask by pressing a precision stamp onto a masking material applied to the surface of the piezoelectric material.

4. The method defined in either one of Claims 1 to 3, wherein the dry etching is started with a less selectively reactive gas for reforming the resist mask to a predetermined thickness profile and then continued with an etching gas having high selective reactivity to the piezoelectric material.
